(19) **Europäisches Patentamt**

**European Patent Office**

**Office européen des brevets**

(11) **EP 0 664 559 B1**

(12) **EUROPEAN PATENT SPECIFICATION**

(45) Date of publication and mention
of the grant of the patent:
**31.05.2000 Bulletin 2000/22**

(51) Int. Cl.$^7$: **H01L 21/3105**, H01L 21/76

(21) Application number: **95100567.7**

(22) Date of filing: **17.01.1995**

(54) **Process for planarizing surface of a semiconductor device**

Verfahren zur Oberflächen-Planarisierung von Halbleiter-Anordnungen

Procédé pour planariser la surface de composants semi-conducteurs

(84) Designated Contracting States:
**DE FR GB**

(30) Priority: **17.01.1994 JP 1794094**

(43) Date of publication of application:
**26.07.1995 Bulletin 1995/30**

(60) Divisional application:
**99119159.4 / 0 977 248**

(73) Proprietor: **SONY CORPORATION**
**Tokyo 141 (JP)**

(72) Inventors:
• **Nagashima, Naoki**
**Tokyo (JP)**

• **Takahashi, Hiroshi**
**Tokyo (JP)**

(74) Representative:
**Müller, Frithjof E., Dipl.-Ing.**
**Patentanwälte**
**MÜLLER & HOFFMANN,**
**Innere Wiener Strasse 17**
**81667 München (DE)**

(56) References cited:
**EP-A- 0 224 646**          **EP-A- 0 545 263**
**EP-A- 0 621 630**

• IBM TECHNICAL DISCLOSURE BULLETIN, vol.
27, no. 8, January 1985 NEW YORK US, pages
4700-4701, BEYER ET AL 'Glass planarization by
stop-layer polishing'

**Description**

BACKGROUND OF THE INVENTION

The present invention relates to a process for planarizing a surface layer of a semiconductor device in a system for producing the semiconductor device, and more particularly to a process for planarizing a trench element isolation region thereof.

In manufacturing a semiconductor device, it is inevitable to form wires on an interlayer insulating layer, by forming isolation regions of, for example, LOCOS structure or wires on the semiconductor substrate, forming wires on the isolation regions, or forming interlayer insulating layers on the semiconductor substrate. By the wires, isolation regions or the like, a remarkable corrugations or convex/concave portions are formed on a surface of the semiconductor substrate on which wires or the like are formed, the interlayer insulating layers on which the wires or the like are formed, the semiconductor substrate on which the isolation regions of LOCOS structure are formed, the semiconductor substrate or the like having wires or the like formed on the isolation regions of LOCOS structure (hereinafter generally referred to as a semiconductor intermediate product). As a result, a height of the surface of the semiconductor intermediate product is locally changed and not plain.

In accordance with the micro-miniaturization tendency in device size of semiconductor integrated circuits, the wavelength of exposure radiation sources used for lithography has become shorter and shorter. An exposure depth of focus is in proportion to an inverse number of the wavelength. As a result, the exposure depth of focus has become shorter and shorter. Accordingly, if remarkable unevenness or corrugation is present on a surface of an intermediate product of the semiconductor device when a photoresist is applied to the surface of the intermediate product of the semiconductor device and the photoresist is exposed, the height of the surface of an integrated circuit locally varies, the exposure position of the photoresist from a projection optical system would not fall within the optimum exposure depth of focus of the projection optical system. As a result, there would be a problem that a line width of the photoresist pattern on the intermediate product of the semiconductor device obtained by carrying out exposure and development of the photoresist would locally vary in the intermediate product of the semiconductor device. Alternatively, there would be another problem that a configuration of the photoresist pattern is displaced or offset from a desired configuration.

Furthermore, when an interconnection layer is to be formed over an interlayer insulating layer, if remarkable corrugations are present on the surface of the interlayer insulating layer, a local variation in thickness of layer would occur in the interconnection layer. If such an interconnection layer is patterned into a desired configuration, the interconnections made from a thin part of the interconnection layer would be thinned and a breakdown voltage of interconnections formed from a thin interconnection layer would be reduced.

Recently, various techniques have been studied and proposed in which formation of corrugations is avoided on the surface of the intermediate product of the semiconductor device as much as possible. Of these techniques, there are proposed, a borophosphosilicate glass (BPSG) reflow method, an insulating layer accumulation etch-back method, an SOG (Spin On Glass) smoothing method, a method wherein surface convex portions are positively etched for planarization, and a planarizing technique that uses polishing.

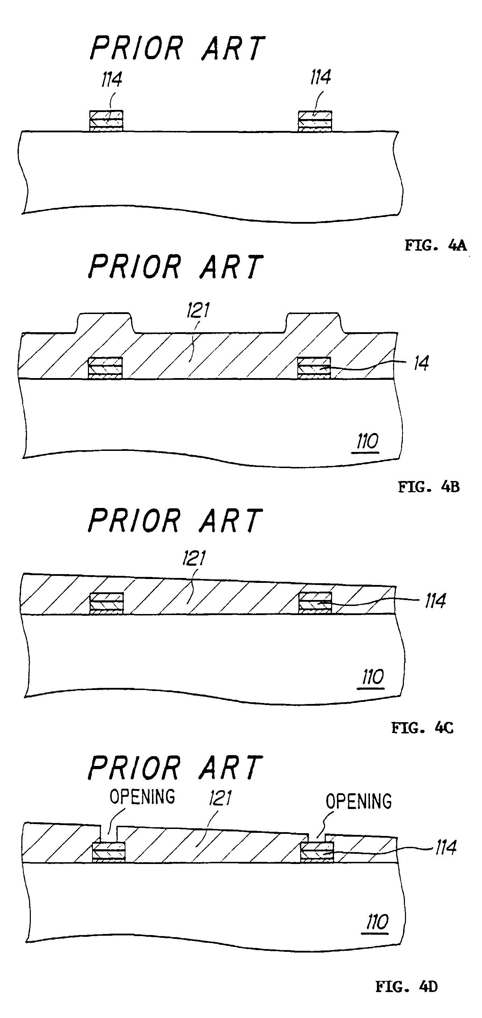

An outline of the polishing planarizing technique will be explained below with reference to Figs. 4A to 4D, which show manufacturing steps.

As shown in Fig. 4A, interconnections 114 are formed on an upper surface of a semiconductor substrate 110. An insulating layer 121 made of silicon oxide is formed on the upper surface of such as a silicon substrate 110 by, for example, a CVD method (see Fig. 4B). Next, as shown in Fig. 4C, the upper surface of the insulating layer 121 is polished to planarize the surface thereof.

On the other hand, the LOCOS method has been conventionally used as an isolation region forming method for the semiconductor device. In the LOCOS method, the silicon semiconductor substrate is selectively thermally oxidized by using a silicon nitride layer as a mask to form an isolation region made of an oxidized layer on the silicon semiconductor substrate. However, upon the thermal oxidization, a so-called birdbeak phenomenon would occur in which the oxidization layer is developed in the horizontal direction of the silicon semiconductor substrate from edge portions of the silicon nitride layer toward the silicon layer. As a result, a conversion difference between a designed mask and a pattern of an actual element separation region would be caused so that it would be difficult to meet a requirement of the micro-miniaturization of the semiconductor elements.

In order to cope with such a problem, a so-called trench element isolation region forming method has been proposed in which trench portions (trenches) are provided on the semiconductor substrate by reactive ion-etching or the like and insulating layers are filled in the trench portions. In the trench element isolation region forming method, after the trench portions (trenches) have been formed in the semiconductor substrate, the insulating layer is accumulated on the surface of the semiconductor substrate as well as the interiors of the trench portions, and the insulating layer is etched back by the reactive ion-etching so that the upper surface of the semiconductor substrate is again exposed while leaving the insulating layers within the trench portions. For example, semiconductor elements are formed on the exposed parts of the semiconductor substrate.

The most significant problem of the conventional trench element isolation region forming method resides in a planarizing method of the insulating layer. Namely, the trench element isolation region forming method based upon such an etch-back technique suffers from a problem that, when the insulating layer is etched back, no insulating layer is left within the trench portion which is large in width for forming a wide field region. Accordingly, in the method using such an etch-back technique, the LOCOS method has to be used together. More specifically, the isolation region is formed for the narrow trench portion by the trench element isolation region forming method, whereas the isolation region (wide field region) is formed for the wide trench portion by the LOCOS method. In such an isolation forming method which requires both the LOCOS method and trench element isolation region forming method, the number of steps is increased and the work is complicated. Therefore, this method is unsuitable for the mass-production of semiconductor devices.

On the other hand, typical planarizing methods in which the amount of the left insulating layer would hardly be changed depending upon a width of the portion where the isolation region is to be formed and in which all the isolation regions may be formed only by the trench element isolation region forming method are, for example, a chemical mechanical polishing method (CMP method), a mechanical polishing method and the like. According to the trench element isolation region forming method based upon the CMP method or the like, it is possible to form a wide element isolation region having a width of 10μm to 1,000μm (i.e., wide field region) and, to considerably reduce the isolation region forming steps. Accordingly, the CMP method or mechanical polishing method has recently been noticed as a trench element isolation region forming method which is the most contributable to the productability.

However, the above-described planarizing method that uses the BPSG reflow method, the insulating layer deposition etch-back method or the SOG smoothing method allows unevenness to be only locally suppressed. Therefore, the conventional method cannot solve the above-described problems in terms of photolithography. The method wherein the surface is planarized by positively etching projections on the surface involves the problems that the etch rate must be controlled and that the number of process steps increases.

With the corrugation smoothing method that uses the polishing planarizing technique, when the insulating layer 121 is polished, the polishing rate or the polishing amount of the insulating layer 121 in a surface of a single wafer (hereinafter simply referred to as a wafer surface) is not uniform. As a result, as shown in Fig. 4C, the layer thickness of the polished insulating layer 121 becomes nonuniform in the wafer surface and further in the semiconductor device intermediate product. Accordingly, the photolithography problems cannot be solved by this method, either. Furthermore, to form connecting holes such as via-holes in the insulating layer 121 above the interconnections 114, it is necessary to form openings in the insulating layer 121 above the interconnections 114 (see Fig. 4D). In the case where the layer thickness of the insulating layer 121 above each interconnection 114 varies, it is necessary to increase the etch rate for the portions of the insulating layer 121 where the layer thickness is relatively large. The method involves a problem that the etching condition of the insulating layer 121 becomes complicated. Also, in a polishing process in which a polishing rate is not kept constant, since the polishing amount depends upon the variation of the polishing rate, it is very difficult to control the layer thickness of the insulating layer 121 after polishing.

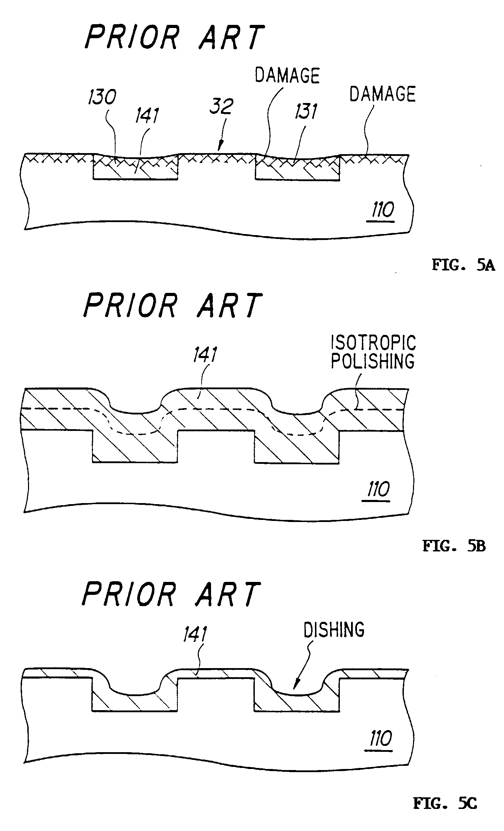

The conventional trench element isolation forming method using the CMP method or mechanical polishing method suffers from two problems. Namely, it involves one problem that the semiconductor substrate including the isolation region formed by polishing would be damaged (see Fig. 5A which is a schematic view) and the other problem of uniformness in polishing the wafer surface. If the damage is generated in the element isolation region, the breakdown voltage of the isolation region is reduced. Also, if the damage is generated in the semiconductor substrate, when the semiconductor element is formed in the region of the semiconductor substrate, for example, a leak current of the semiconductor element, is increased. Incidentally, in Fig. 5A, reference numeral 110 denotes the semiconductor substrate, numeral 130 denotes a bottom portion (recess) of a stepped portion formed in the semiconductor substrate, numeral 141 denotes the insulating layer formed of, for example, $SiO_2$, and numeral 131 denotes the isolation region.

The generation of the damage of the semiconductor substrate may be improved to some extent by sacrificing with the polishing rate or flatness of the insulating layer 141. More specifically, if, for instance, a colloidal silica where a secondary particle diameter of polishing powder used in the CMP method is reduced to a small value (about 10nm or less) is used, and a piece of polishing cloth having a low hardness as a piece of polishing cloth (about 70 to 80 in terms of Asker-C hardness) is used, it is possible to suppress the damage of the semiconductor substrate. However, in this case, the polishing rate is low (about 10nm/min or less), and the amount of removal of convex portions relative to the polishing amount is also small. Accordingly, it takes two hours or more to polish a piece of wafer, and hence, the through-put is extremely low. If the wafer has a large aperture, there is a problem in uniformity of polishing within the wafer. As a result, it is difficult to simultaneously process a plurality of pieces of wafer. Accordingly, it is not practical to solve the problem of generation of the damage of the semiconductor substrate by such a method.

In case of selectively removing the insulating layer by the CMP method, the insulating layer is removed by both chemical reaction of the insulating layer with the polishing liquid and mechanical polishing of the insulating layer by the polishing material. Therefore, in order to solve the problem of the generation of the damage in the semiconductor substrate according to another method, it is possible to use a method for enhancing the chemical polishing characteristics by the CMP method. Namely, there is a method in which a silicon oxide layer or a polycrystalline silicon layer containing impurities is accumulated to form the insulating layer and the latter layer is planarized by the CMP method. The polishing of the insulating layer is developed by the chemical reaction between the impurities contained in the insulating layer and the polishing liquid. Therefore, the generation of the damage of the semiconductor substrate is reduced, and the polishing rate is relatively high at about 100nm/min. Accordingly, there is no problem in through-put.

However, the above-described approach suffers from a problem in which, since the polishing of the insulating layer is isotropically developed by enhancing the chemical polishing property, the layer thickness of the wide bottom portion (recess) of the stepped portion is reduced (so-called dishing). This phenomenon is schematically shown in Figs. 5B and 5C. Incidentally, in Fig. 5B, the position of the surface of the insulating layer 141 which is being polished is indicated by the dotted line.

On the other hand, the problems of non-uniformity in the wafer surface involves two causes. One cause is a distribution (gradient) of the accumulation layer thickness of the insulating layer in the wafer surface, and the other cause is a distribution (gradient) of the polishing rate in the wafer surface. In a current insulating layer accumulation apparatus (for example, CVD apparatus) for processing wafers having a diameter of 8 inches, the distribution (gradient) of the accumulation layer thickness of the insulating layer in the wafer surface is ±3 to 5%. On the other hand, the current chemical mechanical polishing apparatus for processing wafers having a diameter of 8 inches, the polishing rate within the wafer surface is varied in the range of at least about ±3 to 5%.

Accordingly, if these variations are added, the polishing uniformity within the wafer surface is varied in the range of at least ±3 to 5%. In the conventional trench element isolation region forming method, since the insulating layer is made of one kind of material, the polishing or cutting amount of the insulating layer in the wide bottom portion (recess) of the stepped portion formed in the semiconductor substrate is increased. Accordingly, in order to positively leave the insulating layer within the wide bottom portion and to planarize the insulating layer as much as possible, it is necessary to select the thickness of the insulating layer to be accumulated to a height which is approximately twice larger than that of the stepped portion. For instance, if the height of the stepped portion is 0.5μm, the thickness of the insulating layer to be accumulated is about 1μm, and the polishing uniformity in the wafer surface is varied in the range of at least ±50 to 100nm.

Japanese Patent Application Laid-Open No. Sho 59-136943 discloses an isolation region forming method in which the insulating layer which has a thickness that is at least greater than a depth of the groove is accumulated over the entire surface, and thereafter, such an insulating layer is removed by the CMP method. However, in the technique disclosed in this publication, the insulating layer is basically formed of one kind of material or two insulating films each of which is made of material having substantially the same polishing rate. Accordingly, it is difficult to solve the dishing phenomenon problem. Also, since the insulating layer having the greater thickness than the depth of the groove is accumulated over the entire surface, the polishing uniformity within the wafer surface would be degraded.

The documents IBM Technical Disclosure Bulletin, vol. 27, n°8, pages 4700-4701 and EP-A-0 545 263 both disclose the formation of a planarizing layer wherein polishing is used to flatten the top surface of the wafer.

The document EP-A-0 621 630, published on 26.10.1994, discloses the planarization of the surface of a wafer wherein different layers having different polishing rates are alternatively deposited on the surface of the wafer and subsequently polished. The layers having a low polishing rate help in maintaining a good flatness uniformity.

## SUMMARY OF THE INVENTION

Accordingly an object of the present invention is to provide a layer planarizing method for a semiconductor device, to attain excellent controllability of a polishing amount to form a uniform and flat layer without non-uniformity in polishing a wafer surface.

Another object of the invention is to provide a layer planarizing method which establishes the compatibility of preventing any damage to the substrate and making uniform polishing within the wafer surface, which was not attained in the conventional trench element isolation forming step by a chemical mechanical polishing method or a mechanical polishing method.

The invention is defined by the appended claims.

According to an important aspect of the present invention, it is preferable that a value of $T_{2k}$ is greater than or substantially equal to $(H+T_1)$ where H is the height from the lowermost surface to the uppermost portion of the n-times overlapped stepped portions, $T_1$ is the thickness of the first layer in the uppermost portion of the n-times overlapped stepped portions, and $T_{2k}$ is the height from the lowermost surface of the n-times overlapped stepped portions to the top surface of the 2k-th layer ($2 \leq k$). Here it is preferable to meet the following relation although it depends upon the polishing apparatus or the polishing condition:

$$|T_{2k}-(H+T_1)| \leq 0.1\mu m$$

In the case where the value of $T_2k$ is much smaller than that of $(H+T_1)$, in the above-described step for exposing the first layer formed on the top portion of the stepped portion by polishing the 2k-th layer, there is a fear that the uppermost 2k-th layer above the bottom portion of the stepped portion would not be polished. In this case, the smoothness of the entire layer would be worse.

In this case, a height $T_{2j+1}$ from the lowermost portion of the n-times overlapped stepped portions to a surface of the (2j+1)-th layer (where j=1, 2, ..., k-1, 2≤k) is substantially represented by the following condition:

$$T_1 + \sum_{i=n-j+1}^{n} H_i$$

where k is equal to n (i.e., the multi-layer is composed of 2n layers), $T_1$ is the thickness of the first layer on the top portion of the n-times overlapped stepped portions, and $H_1$ is the height of the i-th stepped portion (where i=1, 2, ..., n) from the lowermost portion of the n-times overlapped stepped portions.

Here, the term "substantially equal" is more accurately expressed by the following relation although it depends upon the polishing apparatus or the polishing condition:

$$\left| T_{2j+1} - \left( T_1 + \sum_{i=n-j+i}^{n} H_i \right) \right| \leq 0.1 \mu m$$

Incidentally, the 2m-th layer (where m=1, 2, ..., k, and 2≤k) comprises a laminate of at least one selected from the group essentially consisting of silicon oxide containing impurities and polycrystalline silicon and the (2m-1)-th layer comprises a laminate of at least one selected from the group consisting of silicon oxide and silicon nitride. With such a structure of each layer, it is possible to insure the sufficient polishing rate ratio.

The process according to the invention further comprises, between the step (c) and the step (d), the step of: forming on the 2k-th layer the (2k+1)-th layer having a lower polishing rate than that of the 2k-th layer. In addition, the step (d) comprises the step of polishing the (2k+1)-th layer to the second layer. Thus, the uppermost layer becomes the (2k+1)-th layer having a lower polishing rate so that the uppermost (2k+1)-th layer above the bottom portion of the stepped portion serves as a polishing stopper to further smooth the overall layer.

The process according to the invention further satisfies the following condition, although it depends upon the used polishing apparatus or the polishing conditions:

$$|T_{2k+1}-(H+T_1)|\leq 0.1\mu m$$

where H is the height from the lowermost surface to the uppermost portion of the n-times overlapped stepped portions, $T_1$ is the thickness of the first layer in the uppermost portion of the n-times overlapped stepped portions, and $T_{2k+1}$ is the height from the lowermost surface of the n-times overlapped stepped portions to the top surface of the (2k+1)-th layer. Incidentally, in the case where $T_{2k+1}$ is out of this range, there is a gentle stepped portion on a layer surface defined by each layer. However, depending upon the situation, this is acceptable. It is preferable to meet the following condition although it depends upon the polishing apparatus or the polishing condition:

$$|T_{2k}-(H+T_1)|\leq 0.1\mu m$$

to ensure the exposure of the first layer formed on the top portion of the stepped portion and to further uniformly smooth the entire layer.

Furthermore, a height $T_{2j+1}$ from the lowermost portion of the n-times overlapped stepped portions to a surface of the (2j+1)-th layer (where j=1, 2, ..., k-1, 2≤k) is substantially represented by the following condition:

$$T_1 + \sum_{i=n-j+1}^{n} H_i$$

where k is equal to n (i.e., the multi-layer is composed of (2n+1) layers), $T_1$ is the thickness of the first layer on the top portion of the n-times overlapped stepped portions, and $H_1$ is the height of the i-th stepped portion (where i=1, 2, ..., n) from the lowermost portion of the n-times overlapped stepped portions. Here, the term "substantially equal" is more accurately expressed by the following relation although it depends upon the polishing apparatus or the polishing condition:

$$\left| T_{2j+1} - \left( T_1 + \sum_{i=n-j+1}^{n} H_i \right) \right| \leqq 0.1 \mu m$$

Incidentally, it is preferable that the (2m'-1)-th layer (where m'=1, 2, ..., k+1, and 2≤k) comprises a laminate of at least one selected from the group consisting of silicon oxide and silicon nitride and the 2m-th layer (where m=1, 2, ..., k, and 2≤k) comprises a laminate of at least one selected from the group consisting of silicon oxide containing impurities and polycrystalline silicon. With such a structure, it is possible to insure a sufficient polishing rate ratio.

Throughout the specification, a thickness of each layer, a height of the surface thereof and a height of the stepped portion means arithmetic averages of a suitable number of the measured points.

The polishing of the layers may be carried out by a mechanical polishing method or a chemical mechanical polishing method (CMP method).

In the case where the polishing is carried out by the CMP method, it is necessary to meet the two requirements that the polishing rate of the second layer or the 2m-th layer is high, and the second layer or the 2m-th layer should be chemically polished. However, actually, a layer having a chemical polishability has a higher mechanical polishing rate than a layer having only a mechanical polishability. Accordingly, it is sufficient to select the second layer or the 2m-th layer from material having chemical polishability. However, in the case where the material is limited to the silicon oxide system material, the selection out of the chemical polishable materials is considerably limited. This is because polishing powder of polishing material which is generally used in the field is made of silicon oxide. If an etching property is imparted by mixing HF or the like into the polishing material, the polishing particle is dissolved, resulting in instability in particle diameter of the polishing powder.

Accordingly, the second layer or the 2m-th layer is preferably made of a laminate of silicon oxide containing impurities and/or polycrystal silicon. The silicon oxide containing impurities may be selected form BPSG, PSG, BSG, AsSG, PbSG, SbSG and the like. If the second layer or the 2m-th layer is made of these materials, it is possible to carry out a chemical etching to the materials with, for example, an alkaline polishing solution containing KOH or an alkaline polishing material such as colloidal silica which is usually available on the market. The second layer or the 2m-th layer made of these materials is superior in coverage against the stepped portion.

In order to enhance the coverage of the silicon oxide containing impurities, it is general that the reflow thermal treatment is effected at a high temperature in the range of 900 to 950°C. Accordingly, it is impossible to effect the reflow thermal treatment after formation of wirings made of aluminum or the like. Namely, the desirable coverage characteristics (aspect ratio up to about 1.5) obtained by the reflow thermal treatment are limited by the step where the semiconductor device and the like may stand the high temperature treatment above 900°C. The formation of the trench element isolation region is a pretreatment prior to the formation of the high concentration diffusion layer to the semiconductor body. Accordingly, even if the reflow thermal treatment at 900°C and for about 30 minutes is applied to the oxide silicon containing the impurities, there is no serious problem in the electric characteristics of the semiconductor device. Thus, the usage of BPSG or the like in the formation of the trench element isolation region is effective also to enhance the coverage of the stepped portion.

In the process for planarizing a surface of a semiconductor device according to the present invention (hereinafter simply referred to also as a layer planarizing method), the first layer, the third layer, the (2m-1)-th layer or the (2k+1)-th layer having a lower polishing rate is formed. These layers serve as polishing stoppers in the polishing treatment. Accordingly, it is possible to avoid a reduction in thickness of a layer (dishing) particular in a wide bottom portion (recess portion) of the stepped portion. Also, it is possible to effectively avoid a damage of evenness of the second layer, the 2m-th layer or the 2k-th layer and a reduction in thickness of the overall layers on the bottom portion of the stepped portion exceeding a predetermined level.

In the planarizing method according to the invention, 2k layers which are different in polishing rate are laminated on the topmost portion of the stepped portion. As a result, when the 2k-th layer to the second layer are polished, the first layer formed on the topmost portion of the stepped portion and the (2m-1)-th layers formed above the stepped portion or the bottom portion of each stepped portion serve as stoppers for polishing. As a result, it is possible to avoid a reduction in thickness of the 2m-th layer or the 2k-th layer above the bottom portion of the stepped portion formed in the body, to further enhance the polishing uniformity within the wafer surface and to further effectively suppress the generation of the damage to the body. Also, if (2k+1) layers which are different in polishing rate are laminated on the topmost portion of the stepped portion, when the (2k+1)-th layer to the second layer are polished, the first layer formed on the topmost portion of the stepped portion, the (2m-1)-th layers formed above the stepped portion or the bottom portion of each stepped portion and the (2k+1)-th layer formed above the bottom portion of the stepped portion serve as stoppers for polishing. As a result, it is possible to avoid a reduction in thickness of the 2m-th layer or the 2k-th layer above the bottom portion of the stepped portion formed in the body, to further enhance the polishing uniformity within the wafer surface and to further effectively suppress the generation of the damage to the body.

Furthermore, according to the planarizing method of the invention, it is possible to avoid a reduction in thickness of the layer above the bottom portion of the stepped portion formed in the body and to enhance the polishing uniformity within the wafer surface. It is therefore possible to avoid a problem of an exposure depth of focus in a photolithographic technique and a problem caused by etching of an insulating layer due to non-uniformity in thickness of the insulating layer upon the formation of connection holes.

In addition, in the planarizing method according to an important aspect of the invention, the thickness of the overall layers to be laminated on the entire surface of the substrate or body before polishing is substantially equal to or less than a height of the overall stepped portion, for example. Accordingly, the method steps of the invention, are quite different from the technique disclosed in Japanese Patent Application Laid-Open No. Sho 59-136943. In addition, two or more layers which are different in polishing rate are laminated, so that there is a considerable difference between the layer character (polishing rate) of the layer on the top portion of the stepped portion and the layer character (polishing rate) of the layer above the bottom portion of the stepped portion. Thus, it is possible to make the thickness of the overall layer structure, which has not yet been polished, substantially equal to or less than a height of the stepped portion.

## BRIEF DESCRIPTION OF THE DRAWINGS

In the accompanying drawings:

Figs. 1A, 1B and 1C are schematic partial cross-sectional views showing a body and so on for illustrating each step of a multi layer planarizing method for a semiconductor device according to a first embodiment of the invention;
Figs. 2A, 2B and 2C are schematic partial cross-sectional views showing a body and so on for illustrating further each step of the layer planarizing method for the semiconductor device according to the first embodiment;
Figs. 3A, 3B, and 3C are schematic partial cross-sectional views showing a body and so on for illustrating each step of a multi layer planarizing method for a semiconductor device according to a second embodiment of the invention;
Figs. 4A, 4B, 4C and 4D are schematic partial cross-sectional views showing a body and so on for illustrating an outline of a conventional polishing and planarizing technique; and
Figs. 5A, 5B and 5C schematic partial cross-sectional views showing a body and so on for illustrating problems caused by a conventional trench element isolation region forming method by using a CMP method.

## DESCRIPTION OF THE PREFERRED EMBODIMENTS

The present invention will now be described by way of example with reference to the accompanying drawings.

The following first embodiment is disclosed for illustrative purpose only, and does not form part of the invention.

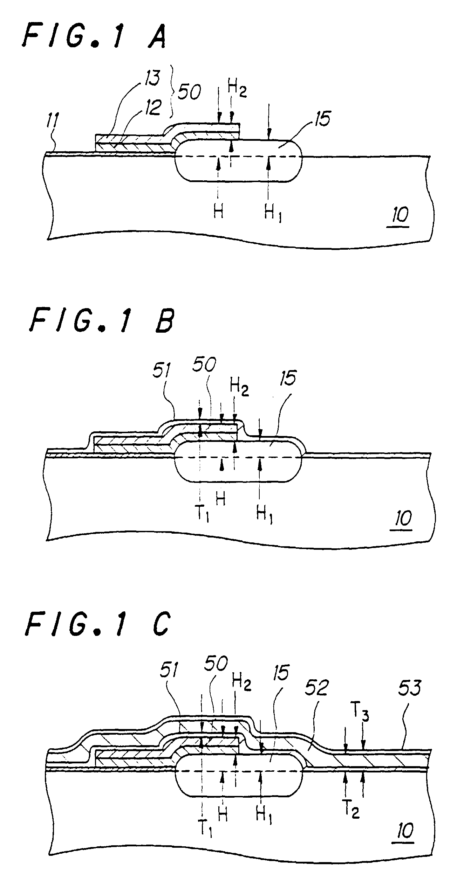

In the first embodiment, it is intended to planarize the insulating layer formed between the interconnection layers and to planarize a so-called interlayer insulating layer. In the first embodiment, a base is composed of a semiconductor body. Also, the stepped portion is composed of an interconnection layer 50 formed on an isolation region 15 having a LOCOS structure formed on the body (see Fig. 1A). Namely, the stepped portion is represented by "double" (i.e., n=2). The first stepped portion is composed of the isolation region 15 having a LOCOS structure, and the second stepped portion is composed of the interconnection layer 50. In the first embodiment, the layer structure above the bottom portion of the stepped portion is represented by four layers (k=2, the second, k-th film being a fourth layer).

The (2m-1)-th film (where m=1, 2, ...k, and k=n=2 in case of this embodiment) is made of silicon oxide ($SiO_2$), whereas the 2m-th film is made of silicon oxide containing impurities (i.e., BPSG). The first layer is applied not only to the top portion of each stepped portion but also to a bottom surface and side walls of the stepped portion. Each film from the 2m-th film to the second film is polished by a chemical mechanical polishing method (CMP). Also, the first layer is used as polishing stoppers not only to improve the uniformity of the polishing effect but also to have a practical function to prevent impurities from being diffused into The body from the second layer made of, for example, BPSG.

In the first embodiment, assuming that H he a height from the lowermost surface of an n-number of the stepped portions to the uppermost surface thereof, $T_1$ be a thickness of the first film in the uppermost portion of the n-number of the stepped portion, and $T_{2k}$ be a height from the lowermost surface of the n-number of the stepped portions to the top surface of the 2k-th film (however, $2 \leq k$), a value of $T_{2k}$ is set to be greater than $(H+T_1)$.

Furthermore, in the first embodiment, a relationship, k=n=2, is established. When $T_1$ is the thickness of the first film in the uppermost portion of the n-number of stepped portion, and $H_i$ is the height of the i-th stepped portion from the lowermost portion of the n-number of stepped portion (where i=1, 2, ..., n), a height $T_{2j+1}$ from the lowermost surface of the n-number of stepped portion to the top surface of the (2j+1)-th film (where j=1, 2, ..., k-1, but $2 \leq k$) is approximately given as follows:

$$T_1 + \sum_{i=n-j+1}^{n} H_i$$

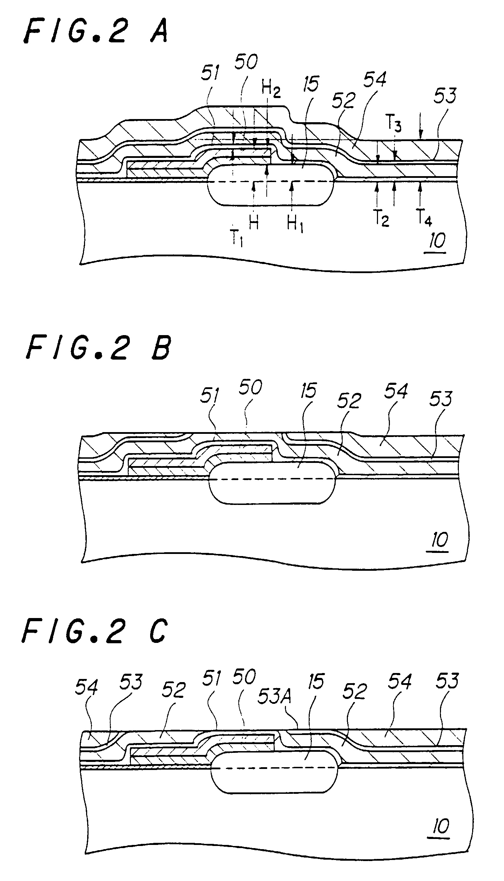

The layer planarizing method in accordance with the first embodiment will now be described with reference to Figs. 1A to 1B and Figs. 2A to 2C which schematically show the body and the like in partial cross section.

[Step 1100]

First of all, an interconnection 50 is formed on an isolation region 15 having a LOCOS structure. The interconnection on the isolation region 15 is composed of, for example, a polycrystalline silicon layer 12 which is doped with phosphorous with a thickness of 0.10μm and a tungsten silicide ($WSi_2$) layer 13 having a thickness of 0.10μm. A height H $(=H_1+H_2)$ from the lowermost surface of the n-number of stepped portions to the uppermost portion thereof is 0-35μm. Namely, the height $H_1$ of the isolation region 15 (i.e., the first stepped portion) is 0.15μm, and the height $H_2$ of the interconnection 50 (i.e., the second stepped portion) is 0.20μm.

[Step 1110]

The n-number of stepped portions (n≥2 note that n=2 is established in the first embodiment) formed on the body 10 are covered by a first film 51 (see Fig. 1B). The first film 51 is set at 0.10μm in thickness. Namely, a thickness $T_1$ of the first film of the uppermost portion of the n-number of stepped portions is 0.10μm.

[Step 1120]

Next, a second layer 52 having a higher polishing rate than that of the first layer 51 is formed to cover each stepped portion with the second layer 52. In the first embodiment, the second layer 52 is formed of a BPSG layer deposited by, for example, a low-pressure CVD method. A thickness of the second layer 52 is set at 0.17μm. Namely, the height $T_2$ is given as follows:

$$T_2 = 0.10\mu m + 0.17\mu m$$
$$= 0.27\mu m$$

[Step 1130]

Thereafter, a third layer 53 (which is the (2m+1)-th film, m=1) having a lower polishing rate than that of the second layer 52 is formed on the surface of the second layer 52 (see Fig. 1C). The third layer 53 may be formed into a silicon oxide layer by a plasma CVD method using, for example, tetraethoxysilane (TEOS). Incidentally, the third layer 53 may be made of silicon nitride ($Si_3N_4$). A thickness of the third layer 53 is set at 30nm. Accordingly, the height $T_3$ from the lowermost surface of the n-number of stepped portions to the surface of the (2m+1=3)-th film 53 is given as follows:

$$T_3 = 0.10\mu m + 0.17\mu m + 0.03\mu m$$
$$= 0.30\mu m$$

On the other hand, since n=2 and j=1, the value of:

$$T_1 + \sum_{i=n-j+1}^{n} H_i$$

is 0.30μm which is the same as $T_3$.

Incidentally, in the layer planarizing method according to the first embodiment, [Step 1120] and [Step 1130] are repeated by (k-1) times, and in the first embodiment, since k=2 is established, [Step 1120] and [Step 1130] are once executed.

[Step 1140]

Thereafter, a 2k-th (fourth) layer 54 having a higher polishing rate than that of a (2k-1)-th (third) layer 53 is formed on the (2k-1)-th layer 53 (see Fig. 2A). This step may be carried out in the same way as [Step 1120]. A thickness of the fourth layer 54 is 0.50μm. The value of ($H+T_1$) is given as follows:

$$(H+T_1) = 0.35\mu m + 0.10\mu m$$
$$= 0.45\mu m$$

Also, a height $T_{2k}$ from the lowermost surface of the n-number (double) of stepped portions to the surface of the (2k=4)-th layer 54 is given as follows.

$$T_4 = 0.10\mu m + 0.17\mu m + 0.03\mu m + 0.50\mu m$$
$$= 0.80\mu m$$

Therefore, the value of $T_2k$ is greater than the value of ($H+T_1$).

[Step-1150]

Thereafter, the polishing treatment is effected from the (2k=4)-th layer 54 to the second layer 52 to expose the first layer formed on the outermost position of the n-times overlapped stepped portions. Fig. 2B is a schematic partial cross-sectional view showing the body and the like under the polishing treatment. Also, Fig. 2C is a schematic partial cross-sectional view showing the body and the like upon completion of the polishing treatment.

A height $H_1$ of the first stepped portion is 0.15μm. On the other hand, a height of the third layer 53 formed above the first stepped portion with reference to the surface of the body 10 which is the lowermost surface of the stepped portion is given as follows:

$$H_1 + T_3 = 0.15\mu m + 0.30\mu m$$
$$= 0.45\mu m$$

Accordingly, with reference to the surface of the body 10 which is the lowermost surface of the stepped portion, the height of the third layer 53 formed above the first stepped portion is equal to the height of the surface of the first layer on the top portion of the n-number of the stepped portions.

Therefore, when the polishing treatment is effected from the 2k-th layer (the fourth layer 54 in the first embodiment) to the second layer 52 to expose the first layer 51 formed on the top portion of the n-number of stepped portions, not only does the first layer 51 formed on the top portion of the n-number of stepped portions serve as a stopper but also the (2m+1)-th layer formed above the first stepped portion (i.e., the third layer 53 according to the first embodiment in Fig. 2C) serves as a stopper. Accordingly, it is possible to effectively suppress the excessive polishing of the k-th layer (i.e., fourth layer 54) or the 2m-th layer (i.e., second layer 52).

Incidentally, the 2m-th layer (where m=1, 2, ...,k, 2≤k) may be made of polycrystalline silicon or a laminate of silicon oxide containing impurities and polycrystalline silicon. Also, the (2m-1)-th layer may be made of silicon nitride or a laminate of silicon oxide and silicon nitride.

Thus, an insulating multi-layer formed between the n-times overlapped stepped portions and whose surface is planarized by the lamination of the 2k insulating layers is produced by the layer planarizing method in accordance with the first embodiment. The first layer of the insulating multi-layer covers the top portion of the n-times overlapped stepped portions. On the other hand, a part of the surface of the insulating multi-layer above the bottom portion of the stepped portions is composed of the 2k-th layer. The 2m'-th layer (where m'=1, 2, ..., k-1, 2≤k) and the (2m'+1)-th layer are exposed between the first layer of the insulating layer which covers the top portion of the n-times overlapped stepped portions and the 2k-th layer thereof. The 2m'-th layer has a higher polishing rate than that of the (2m'±1)-th layer. Furthermore, the 2k-th layer has a higher polishing rate than that of the (2k-1)-th layer.

A second embodiment is a modification of the first embodiment and represents the invention. The second embodiment is different from the first embodiment in that a (2k+1)-th layer (i.e., fifth layer 55 in the second embodiment) which has a lower polishing rate than that of a 2k-th layer (i.e., fourth layer 54 in the second embodiment) is formed on the 2k-th layer between [Step 1140] and [Step 1150] of the first embodiment, in that in [Step 1150] of the first embodiment, the (2k+1)-th layer (i.e., fifth layer 55 in the second embodiment) to the second layer are polished, and a layer thickness of the 2k-th layer (i.e., fourth layer 54 in the second embodiment) is varied from that of the first embodiment. In the second embodiment, five layers (2k+1=2x2+1) are laid above the bottom portion of the stepped portions. The fifth layer 55 is made of silicon oxide ($SiO_2$).

Incidentally, also in the second embodiment, assuming that k is equal to n, i.e., 2, $T_1$ is the thickness of the first layer on the top portion of the n-times overlapped stepped portions, and $H_1$ is the height of the i-th stepped portion (where i=1, 2, ..., n) from the lowermost portion of the n-times overlapped stepped portions, a height $T_{2j+1}$ from the bottom surface of the n-times overlapped stepped portions to the surface of the (2j+1)-th layer (where j=1, 2, ..., k-1, 2≤k) is approximately the same as the value given as follows:

$$T_1 + \sum_{i=n-j+1}^{n} H_i$$

The layer planarizing method according to the second embodiment will now be described with reference to Figs. 3A to 3C which are schematic, partial cross-sectional views of the body and the like.

[Step 1200]

First of all, in the same way as [Step 1100], an interconnection 50 is formed on an isolation region 15 having a LOCOS structure. A height $H_1$ of the isolation region 15 which forms the first stepped portion is 0.15μm, and a height $H_2$ of the interconnection layer 50 which forms the second stepped portion is 0.20μm. A height H ($=H_1+H_2$) from the lowermost surface of the n-times overlapped stepped portions to the uppermost portion thereof is 0.35μm.

[Step 1210]

In the same manner as [Step 1110] of the first embodiment, the n-number of stepped portions (n≥2, note that n=2 is established in the second embodiment) formed on the body 10 are covered by a first layer 51 which is made of silicon oxide ($SiO_2$). The first layer 51 is set at 0.10μm in thickness. Namely, a thickness $T_1$ of the first layer of the uppermost portion of the n-number of stepped portions is 0.10μm.

[Step 1220]

Next, in the same manner as [Step 1120] of the first embodiment, a second layer 52 having a higher polishing rate than that of the first layer 51 is formed to cover each stepped portion with the second layer 52. A thickness of the second layer 52 is set at 0.17μm. Namely, the height $T_2$ is given as follows:

$$T_2=0.10\mu m + 0.17\mu m$$
$$=0.27\mu m$$

[Step 1230]

Thereafter, in the same manner as [Step 1130] of the first embodiment, a third layer 53 (which is the (2m+1)-th film, m=1) having a lower polishing rate than that of the second layer 52 is formed on the surface of the second layer 52. A thickness of the third layer 53 is set at 30nm. Accordingly, the height $T_3$ from the lowermost surface of the n-number of stepped portions to the surface of the (2m+1=3)-th layer 53 is given as follows:

$$T_3=0.10\mu m + 0.17\mu m + 0.03\mu m$$
$$=0.30\mu m$$

On the other hand, since n=2 and j=1, the value of:

$$T_1 + \sum_{i=n-j+1}^{n} H_i$$

is 0.30μm which is the same as $T_3$.

Incidentally, k is set at 2 also in the second embodiment. Accordingly, in the second embodiment, the fact that [Step 1120] and [Step 1130] are repeated by (k-1) times means that [Step 1120] and [Step 1130] are once executed.

[Step 1240]

Thereafter, a 2k-th (fourth) layer 54 having a higher polishing rate than that of a (2k-1)-th (third) layer 53 is formed on the (2k-1)-th layer 53 (see Fig. 3A). This step may be carried out basically in the same way as [Step 1220]. A thickness of the fourth layer 54 is 0.12μm. The value of (H+$T_1$) is given as follows:

$$(H+T_1)=0.35\mu m+0.10\mu m$$
$$=0.45\mu m$$

Also, a height $T_{2k}$ from the lowermost surface of the n-number (double) of stepped portions to the surface of the (2k=4)-th layer 54 is given as follows.

$$T_4=0.10\mu m + 0.17\mu m + 0.03\mu m + 0.12\mu m$$
$$=0.42\mu m$$

Therefore, the value of $T_{2k}$ is smaller than the value of (H+$T_1$).

[Step 1250]

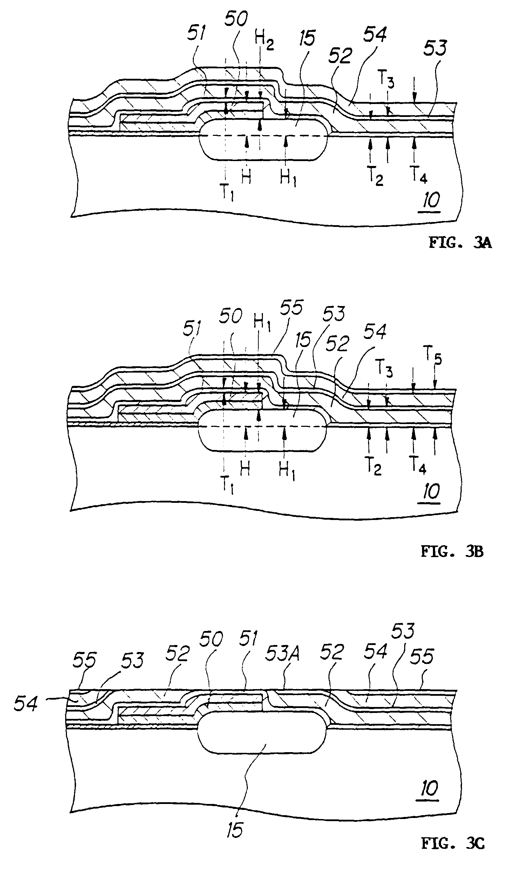

Subsequently, a (2k+1)-th layer, i.e., fifth layer 55 which has a lower polishing rate than that of a 2k-th layer, i.e., fourth layer 54 is formed on the 2k-th layer 54 (see Fig. 3B). The fifth layer 55 may be formed into a silicon oxide layer by a plasma CVD method using, for example, tetraethoxysilane (TEOS). Incidentally, the fifth layer 55 may be made of silicon nitride ($Si_3N_4$). A thickness of the fifth layer 55 is set at 30nm. Accordingly, the height $T_5$ from the lowermost surface of the n-number of stepped portions to the surface of the (2k+1=5)-th layer 55 is given as follows:

$$T_5 = 0.10\mu m + 0.17\mu m + 0.03\mu m + 0.12\mu m + 0.03\mu m$$
$$= 0.45\mu m$$

Assuming that H be the height from the lowermost surface of the n-times overlapped stepped portions to the top portion thereof and $T_{2k+1}$ be the height from the lowermost surface of the n-times overlapped stepped portions to the surface of the (2k+1)-th layer 55, $T_{2k+1}$ is equal to $H+T_1$. Accordingly, the second embodiment meets the following relationship.

$$|T_3 - (H + T_1)| \leq 0.1\mu m$$

[Step 1260]

Thereafter, the polishing treatment is effected from the (2k+1=5)-th layer 55 to the second layer 52 to expose the first layer formed on the outermost position of the n-times overlapped stepped portions. This step may be carried out in the same way as [Step 1150] of the first embodiment. Fig. 3C is a schematic partial cross-sectional view showing the body and the like upon completion of the polishing treatment.

A height $H_1$ of the first stepped portion is 0.15μm. On the other hand, a height of the third layer 53 formed above the first stepped portion with reference to the surface of the body 10 which is the lowermost surface of the stepped portion is given as follows:

$$H_1 + T_3 = 0.15\mu m + 0.30\mu m$$
$$= 0.45\mu m$$

Accordingly, with reference to the surface of the body 10 which is the lowermost surface of the stepped portion, the height of the fifth layer 55 formed above the bottom portion of the stepped portion and the height of the third layer 53 formed above the first stepped portion is equal to the height of the surface of the first layer on the top portion of the n-number of the stepped portions.

Therefore, when the polishing treatment is effected from the (2k+1)-th layer to the second layer 52 to expose the first layer 51 formed on the top portion of the n-number of stepped portions, not only do the first layer 51 formed on the top portion of the n-number of stepped portions and the fifth layer 55 formed above the bottom portion of the stepped portions serve as stoppers but also the third layer formed above the first stepped portion serves as a stopper. Accordingly, it is possible to further effectively suppress the excessive polishing of the forth layer 54 or the second layer 52.

Incidentally, the 2m'-th layer (where m'=1, 2, ...,k+1, 2≤k) may be made of silicon nitride or a laminate of silicon oxide and silicon nitride. Also, the 2m-th layer may be made of polycrystalline silicon or a laminate of silicon oxide containing impurities and polycrystalline silicon.

Thus, an insulating multi-layer formed between the n-times overlapped stepped portions and whose surface is planarized by the lamination of the (2k+1) insulating layers is produced by the layer planarizing method in accordance with the second embodiment. The first layer of the insulating multi-layer covers the top portion of the n-times overlapped stepped portions. On the other hand, a part of the surface of the insulating multi-layer above the bottom portion of the stepped portions is composed of the (2k+1)-th layer. The 2m-th layer (where m=1, 2, ..., k, 2≤k) and the (2m+1)-th layer (where m=1, 2, ..., k-1, 2≤k) are exposed between the first layer of the insulating layer which covers the top portion of the n-times overlapped stepped portions and the (2k+1)-th layer thereof. The 2m-th layer has a higher polishing rate than that of the (2m±1)-th layer. Furthermore, the (2k+1)-th layer has a higher polishing rate than that of the 2k-th layer.

A third embodiment is a modification of the second embodiment. The third embodiment is different from the second embodiment in thickness of the 2m-th layer (where m=1, 2, ..., k, 2≤k).

Namely in the second embodiment, assuming that k is equal to n, i.e., 2, $T_1$ is the thickness of the first layer on the top portion of the n-times overlapped stepped portions, and $H_1$ is the height of the i-th stepped portion (where i=1, 2, ..., n) from the lowermost portion of the n-times overlapped stepped portions, a height $T_{2j+1}$ from the bottom surface of the n-times overlapped stepped portions to the surface of the (2j+1)-th layer (where j=1, 2, ..., k-1, 2≤k) is approximately the same as the value given as follows:

$$T_1 + \sum_{i=n-j+1}^{n} H_i$$

On the other hand, in the third embodiment, assuming that k is equal to n, i.e., 2, $T_1$ is the thickness of the first layer on the top portion of the n-times overlapped stepped portions, and $H_1$ is the height of the i-th stepped portion (where i=1, 2, ..., n) from the lowermost portion of the n-times overlapped stepped portions, a height $T_{2j+1}$ from the bottom surface of the n-times overlapped stepped portions to the surface of the (2j+1)-th layer (where j=1, 2, ..., k-1, $2 \leq k$) is approximately the same as $T_1+H_1$.

The layer thickness from the first layer 51 to the fifth layer 55 is shown below.

First layer 51: 0.10μm
Second layer 52: 0.12μm
Third layer 53: 0.03μm
Fourth layer 54: 0.17μm
Fifth layer 55: 0.03μm

Each step of the layer planarizing method according to the third embodiment may be carried out in the same way as the second embodiment and hence detailed explanation therefor will be omitted.

Also in the third embodiment, when the polishing treatment is effected from the (2k+1)-th layer to the second layer 52 to expose the first layer formed on the top portion of the n-number of stepped portions, not only do the first layer 51 formed on the top portion of the n-number of stepped portions and the fifth layer 55 formed above the bottom portion of the stepped portions serve as stoppers but also the third layer formed above the first stepped portion serves as a stopper. Accordingly, it is possible to further effectively suppress the excessive polishing of the forth layer 54 or the second layer 52.

The foregoing description of the embodiments according to the present invention is provided for the purpose of illustration only. For example, the stepped portions may be formed by any other elements than the interconnections and isolation regions.

In the foregoing embodiments, the interconnections 50 are the gate electrodes of MOS type transistors or extensions of the gate electrodes. However, the interconnections 50 are not limited to those and it is possible to modify them in various manner as desired. Also, the bodys 10 are not limited to silicon semiconductor bodys. For instance, it is possible to form the bodys of compound semiconductor bodys such as GaAs or the like. Furthermore, it is possible to use, as a body structure, a body 10 for a trench element isolation region formed in the silicon semiconductor body and an interconnection formed in the trench element isolation region.

In the second and third embodiments representing the invention, the number of the stages of the stepped portions is two but it is possible to use any other number of the stages. In the embodiments, k=n=2 is established for explanation but it is sufficient that n is one or more. Also, the value of k is two or more and may be less than or greater than n. Which aspect should be used from the second and third embodiments as the planarizing method may be determined on the basis of a shape or a height of the stepped portions and an interval between the stepped portions.

As described above, according to the planarizing method according to the present invention, since the polishing for planarization is carried out after laminating the first layer and the second layer having a lower polishing rate than that of the first layer or alternatively laminating layers having slow polishing rate and high polishing rate, the first layer formed on above the top portion of the stepped portion and/or the layers having the slow polishing rate serve as polishing stoppers. Accordingly, it is possible to control the polishing treatment of the second layer and/or other layers having the high polishing rate by the first layer and/or other layers having the slow polishing rate. It is therefore possible to effectively prevent any local generation of corrugations on the layers of the body which have been polished. Consequently, it is possible to realize the layer planarization by the polishing treatment without non-uniformity. In addition, it is possible to enhance the controllability of the layer thickness because the first layer and the layers having the slow polishing rate are used as the polishing stoppers. Moreover, even if each layer would be excessively polished, it is possible to prevent it from being polished exceeding a predetermined layer thickness to thereby enhance the uniformity in polishing within the wafer surface.

As a result, it is possible to increase a margin of an exposure depth of focus upon the exposure in the photolithographic process. Also, since it is possible to reduce an amount of over-etching upon the formation of connection holes, it is possible to enhance reliability of interconnections. Also, upon the planarization of the trench element isolation region through the polishing method, it is possible to establish the compatibility of preventing any damage to the body and smoothing the surface of the body, and the isolation regions. It is also possible to ensure the polishing treatment in which any reduction in thickness of the layers even in the wide element isolation regions (i.e., dishing) is not present. Accordingly, the yield of production of semiconductor devices is enhanced and the mass-production may readily be attained.

Also, in the planarizing method according to the invention, since the surface of the (2k+1)-th layer is set at a level in the range of $\pm 1\mu m$ relative to the surface of the first layer formed on the top portion of the stepped portions, it is possible to ensure a sufficient polishing allowance. Accordingly, it is possible to polish each surface substantially in a flat surface.

Furthermore, according to the present invention, by suitably selecting material that makes the 2m-th layer and the $(2m\pm1)$-th layer, it is possible to obtain a sufficient polishing rate relative to each layer.

**Claims**

1.  A process for planarizing a surface of a semiconductor device, comprising the steps of:

    (a) covering, with a first layer (51), a plurality of n-times overlapped stepped portions (15, 50) formed on a body (10), H being the height from the lowermost surface on said body's surface to the uppermost portion of the n-times overlapped stepped portions, and T1 being the thickness of the first layer (51) on the uppermost portion of the n-times overlapped stepped portions;

    (b) carrying out (k-1) times the steps of forming on a (2m-1)-th layer (51, 53) a 2m-th layer (52, 54) having a higher polishing rate than that of said (2m-1)-th layer (51, 53), where m is 1, 2, ..., k, and (2≤k), and subsequently forming on a 2m-th layer (52) a (2m+1)-th layer (53) having a lower polishing rate than that of said 2m-th layer;

    (c) forming on a (2k-1)-th layer (53) a 2k-th layer (54) having a higher polishing rate than that of said (2k-1)-th layer (53); and forming on the 2k-th layer a (2k+1)-th layer having a lower polishing rate than that of the 2k-th layer, $T_{2k}{\geq}H$ being the height from the lowermost surface of the n-times overlapped stepped portions on the body's (10) surface to the top surface of the 2k-th layer in non-stepped regions on said body (10) and in non-polished state, and $T_{2k+1}$ being the height from the lowermost surface of the n-times overlapped stepped portions on said body's (10) surface to the top surface of the (2k+1)-th layer in non-stepped regions on said body (10) and in non-polished state; and

    (d) polishing the (2k+1)-th layer to the second layer (52) to expose the first layer (51) formed on an uppermost portion of said n-times overlapped stepped portions, wherein following tolerance condition is satisfied:

$$|T_{2k+1}-(H+T_1)|{\leq}0{,}1\mu m.$$

2.  The process according to claim 1, wherein the (2m-1)-th layer (where m=1, 2, ..., k+1, and 2≤k) comprises a laminate of at least one selected from the group consisting of silicon oxide and silicon nitride and the 2m-th layer (where m=1, 2, ..., k, and 2≤k) comprises a laminate of at least one selected from the group consisting of silicon oxide containing impurities and polycrystalline silicon.

**Patentansprüche**

1.  Verfahren zum Einebnen einer Fläche eines Halbleiterbauteils mit den folgenden Schritten:

    (a) Bedecken mehrerer n-fach überlappender, auf einem Körper (10) ausgebildeter Stufenabschnitte (15, 50) mit einer ersten Schicht (51), wobei H die Höhe von der untersten Fläche auf der Fläche des Körpers bis zum obersten Teil der n-fach überlappenden Stufenabschnitte ist und T1 die Dicke der ersten Schicht (51) auf dem obersten Teil der n-fach überlappenden Stufenabschnitte ist;

    (b) (k-1)-maliges Ausführen der Schritte des Herstellens einer Schicht 2m (52, 54) mit höherer Polierrate als derjenigen einer Schicht 2m-1 (51, 53) auf dieser Schicht 2m-1 (51, 53), mit m=1, 2, ..., k und 2≤k; und anschließendes Herstellen einer Schicht 2m+1 (53) mit niedrigerer Polierrate als der einer Schicht 2m auf dieser Schicht 2m (52);

    (c) Herstellen einer Schicht 2k (54) mit höherer Polierrate als der einer Schicht 2k-1 (53) auf dieser Schicht 2k-1 (53); und

    -    Herstellen einer Schicht 2k+1 mit niedrigerer Polierrate als der der Schicht 2k auf dieser Schicht 2k, wobei $T_{2k}{\geq}H$ die Höhe von der untersten Fläche der n-fach überlappenden Stufenabschnitte auf der Oberfläche

**14**

des Körpers (10) bis zur obersten Fläche der Schicht 2k im unpolierten Zustand auf Nichtstufenbereichen des Körpers (10) ist und $T_{2k+1}$ die Höhe von der untersten Fläche der n-fach überlappenden Stufenabschnitte auf der Oberfläche des Körpers (10) bis zur obersten Fläche der Schicht 2k+1 im unpolierten Zustand in Nichtstufenbereichen auf dem Körper (10) ist; und

(d) Polieren der Schicht 2k+1 bis zur zweiten Schicht (52), um die erste Schicht (51) freizulegen, die auf dem obersten Teil der n-fach überlappenden Stufenabschnitte ausgebildet ist;

- wobei die folgende Toleranzbedingung erfüllt ist:

$$|T_{2k+1}-(H+T_1)|\leq 0,1\mu m$$

2. Verfahren nach Anspruch 1, bei dem die Schicht 2m'-1. (mit m'=1, 2, ..., k+1; und 2≤k) ein Laminat aus mindestens einem Material aufweist, das aus der aus Siliciumoxid und Siliciumnitrid bestehenden Gruppe ausgewählt ist, und die Schicht 2m (mit m=1, 2, ..., k; und 2≤k) ein Laminat aus mindestens einem Material aufweist, das aus der Gruppe ausgewählt ist, die aus Fremdstoffe enthaltendem Siliciumoxid und polykristallinem Silicium besteht.

**Revendications**

1. Procédé de mise sous forme plane d'une surface d'un dispositif à semi-conducteur, comprenant les étapes suivantes :

(a) le recouvrement, par une première couche (51), de plusieurs parties à gradins (15, 50) recouvertes n fois et qui sont formées sur un corps (10), H étant la hauteur par rapport à la surface la plus basse entre la surface du corps et la partie supérieure des parties à gradins recouvertes n fois, et T1 étant l'épaisseur de la première couche (51) sur la partie supérieure des parties à gradins recouvertes n fois,
(b) l'exécution (k-1) fois d'étapes de formation, sur une $(2m-1)^e$ couche (51, 53), d'une $2m^e$ couche (52, 54) ayant une vitesse de polissage supérieure à celle de la $(2m-1)^e$ couche (51, 53), m étant égal à 1, 2,...k et $2 \leq k$, puis de formation, sur une $2m^e$ couche (52), d'une $(2m+1)^e$ couche (53) ayant une plus faible vitesse de polissage que la $2m^e$ couche,
(c) la formation, sur une $(2k-1)^e$ couche (53), d'une $2k^e$ couche (54) ayant une vitesse de polissage supérieure à celle de la $(2k-1)^e$ couche (53), et la formation, sur la $2k^e$ couche, d'une $(2k+1)^e$ couche ayant une vitesse de polissage inférieure à celle de la $2k^e$ couche, $t_{2k} \geq H$ étant la hauteur par rapport à la surface inférieure entre des parties à gradins recouvertes n fois à la surface du corps (10) et la surface supérieure de la $2k^e$ couche dans les régions sans gradins sur le corps (10) et à l'état non poli, et $T_{2k+1}$ étant la hauteur comprise entre la surface la plus basse des parties à gradins recouvertes n fois à la surface du corps (10) et la surface supérieure de la $(2k+1)^e$ couche dans des régions sans gradins, sur le corps (10) et à l'état non poli, et
(d) le polissage de la couche jusqu'à la seconde couche (52) afin que la première couche (51) formée sur la partie supérieure des parties à gradins recouvertes n fois soit exposée,

et la condition suivante de tolérances est respectée :

$$|T_{2k+1} - (H + T_1)| \leq 0,1 \ \mu m.$$

2. Procédé selon la revendication 1, dans lequel la $(2m-1)^e$ couche (avec m = 1, 2,...k+1 et $2 \leq k$) est un stratifié d'au moins un matériau choisi dans le groupe constitué par l'oxyde de silicium et le nitrure de silicium et la $2m^e$ couche (avec m = 1, 2,...k et $2 \leq k$) est un stratifié d'au moins un matériau choisi dans le groupe formé par de l'oxyde de silicium contenant des impuretés et du silicium polycristallin.

# FIG. 1 A

# FIG. 1 B

# FIG. 1 C

## FIG. 2 A

## FIG. 2 B

## FIG. 2 C

FIG. 3A

FIG. 3B

FIG. 3C

PRIOR ART

114          114

FIG. 4A

PRIOR ART

121

14

110

FIG. 4B

PRIOR ART

121

114

110

FIG. 4C

PRIOR ART

OPENING   121        OPENING

114

110

FIG. 4D

PRIOR ART

FIG. 5A

PRIOR ART

FIG. 5B

PRIOR ART

FIG. 5C